# EUROPÄISCHE PATENTSCHRIFT

(11) **EP 1 038 593 B1**
(45) Veröffentlichungstag und Bekanntmachung des Hinweises auf die Patenterteilung: **04.10.2000**
(21) Anmeldenummer: 99106780.2
(22) Anmeldetag: 06.04.1999
(51) Int. Cl.: B05C 11/08, G03F 7/16, B05B 15/10

(54) **Einrichtung zum Austrag von zwei oder mehreren Medien mit Mediendüsen**
Device for applying two or several fluids from nozzles
Dispositif pour l'application de deux ou plusieurs fluides par des buses

(43) Veröffentlichungstag der Anmeldung: 27.09.2000
(73) Patentinhaber: SEZ Semiconductor-Equipment Zubehör für die Halbleiterfertigung AG, 9500 Villach (AT)
(72) Erfinder: Sumnitsch, Franz, 9020 Klagenfurt (AT)

(56) Entgegenhaltungen:
- US-A- 5 514 215

## Beschreibung

Die Erfindung gemäß Anspruch 1 betrifft eine Einrichtung zum Austrag von zwei oder mehreren Medien mit Mediendüsen nach dem Oberbegriff von Anspruch 1 (vgl. die US-A-5514215).

Derartige Mediendüsen werden z.B. bei der Behandlung von scheibenförmigen Gegenständen wie Halbleiterscheiben (Wafer, z.B. Siliziumwafer) verwendet. Auch können sie beim Behandeln von Flachbildschirmen (Flat Panel Display) bei ihrer Herstellung zum Einsatz kommen. Dabei kann es sich um speziell geformte Düsen handeln, oder einfach um die offene Mündung einer Leitung.

Unter Medienarm wird ein im wesentlichen starrer Arm verstanden, der gebogen oder gerade sein kann. Die Leitung, die zur Mediendüse führt, kann entweder außerhalb des Medienarms, oder wenn dieser z.B. ein Rohr ist, innerhalb geführt werden.

Die Medien, die durch die Mediendüsen ausgetragen werden, können Flüssigkeiten, wie z.B. Kunstharzlösungen (beispielsweise Photoresist) Reinigungsmittel, Ätzmittel oder Lösungsmittel, aber auch Gase, wie z.B. Luft oder Reinststickstoff sein. Derartige Medien werden für die Behandlung von Halbleiterscheiben (Wafer) verwendet. Die Behandlung kann z.B. eine Beschichtung, Ätzung und/oder Reinigung sein. Im Falle der Verwendung von Gasen wird dies zum Trocknen sein. Dem Gas kann auch ein Dampf eines Alkohols (z.B. Isopropanol) beigemischt sein.

Unter Schwenken sei eine Rotationsbewegung verstanden, bei der die Medienarme in einem Winkel zur Rotationsachse (Schwenkachse) angebracht sind. Die am Ende des Medienarmes montierte Mediendüse beschreibt somit eine Kreisbahn. Die Bewegung der Düse erfolgt zwischen einer Ruheposition und einer Arbeitsposition, oder sie wird im eingeschalteten Zustand (Medium fließt) zwischen zwei Umkehrpositionen hin- und herbewegt.

Weiters betrifft die Erfindung eine Vorrichtung zum Behandeln von jeweils einem scheibenförmigen Gegenstand mit mindestens zwei Medien mit einem Träger zum Halten des scheibenförmigen Gegenstands, bei der eine derartige Einrichtung zum Einsatz kommt. Die zwei Medien werden dabei hintereinander aufgebracht. Das erste Medium kann eine Reinigungslösung sein, das zweite ein Trocknungsgas.

In der US 5,089,305 werden verschiedene Arten derartiger Einrichtungen, mit denen zwei oder mehrere Medien insbesondere auf eine rotierende Halbleiterscheibe aufgebracht werden können, beschrieben.

In einer in der US 5,089,305 beschriebenen Vorrichtung wird ein Medienarm, der zwei Düsen trägt, durch einen Linearmotor bewegt. Nachteil dieser Vorrichtung ist, daß wenn ein Medium aufgetragen wird und währenddessen aus der Düse des anderen Mediums ein Tropfen entweicht, dieser unerwünschterweise die Oberfläche der Halbleiterscheibe (Wafer) benetzt. Dies kann im schlimmsten Fall zur Zerstörung des Wafers, beziehungsweise der auf ihm befindlichen Strukturen führen.

Bei einer weiteren in der US 5,089,305 beschriebenen Vorrichtung wird dieses Problem gelöst, indem die Mediendüsen auf getrennten Medienarmen befestigt sind. Die Medienarme werden von der Ruheposition in die Arbeitsposition geschwenkt. Nachteil dieser Vorrichtung ist, daß für jeden Medienarm sowohl Platz als auch ein eigener Antriebsmechanismus zur Verfügung gestellt werden muß.

Die dritte Vorrichtung der US 5,089,305 sieht einen einzelnen Medienarm vor, der verschiedene Mediendüsen aus einer Ruheposition (Stand-By-Position) entnehmen kann und diese so getrennt von einander in eine Arbeitsposition bringen kann. Der Medienarm durch zwei Linearmotoren bewegt werden oder als Gelenkarm ausgeführt sein. In beiden Fällen benötigt der Antriebsmechanismus viel Platz und ist sehr aufwendig. Außerdem ist für einen störungsfreien Betrieb zur Entnahme der Mediendüsen aus den Ruhepositionen eine extrem genaue Einstellung der Vorrichtung notwendig, was zusätzlichen Aufwand mit sich bringt.

Insoweit liegt der Erfindung die Aufgabe zugrunde, eine Einrichtung vorzuschlagen, die mehrere Medien in zeitlicher Abfolge aus unterschiedlichen Düsen austragen kann, das Problem des Nachtropfens löst und den Mechanismus der US-A-5514215 durch einen einfachenen, leicht zu steuernden Mechanismus ersetzt.

Demzufolge schägt die Erfindung in ihrer allgemeinsten Ausführungsform eine Einrichtung gemäß Anspruch 1 von.

Aus jeder Mediendüse kann ein Medium (Gas oder Flüssigkeit) ausgetragen werden. Jeder Mediendüse ist ein Medienarm zugeordnet, damit sichergestellt werden kann, daß, wenn die Mediendüse nicht in Betrieb ist (Medium strömt nicht), diese sich in einer Ruheposition befinden kann.

Durch je eine Aufhängung für je einen Medienarm wird gewährleistet, daß diese getrennt von einander bewegt werden können. Die Aufhängung ist so auszuführen, daß die Schwenkbewegung (Rotationsbewegung) der Medienarme um eine gemeinsame Rotationsachse (Schwenkachse) durchgeführt wird.

In dieser allgemeinsten Ausführungsform kann jedem Medienarm eine eigene Antriebseinheit (Motor) zugeordnet sein.

Wesentlichster Vorteil der Erfindung gegenüber dem Stand der Technik ist, daß die nicht benötigten Mediendüsen in einer Ruheposition verweilen können und trotzdem fix auf dem jeweils zugeordneten Medienarm montiert bleiben und dabei die Einrichtung nur wenig Platzbedarf hat.

Damit die Medienarme nicht nach ihrem Einsatz aus dem Wirkungsbereich der anderen entfernt werden müssen, sind sie in einer Ausführungsform zur Durchführung der Schwenkbewegung frei drehbar auf einer gemeinsamen Achse so angebracht, daß sie einander bei Durchführung der Schwenkbewegung nicht behindern.

Eine Ausführungsform sieht eine Antriebseinheit zur Durchführung der Schwenkbewegungen vor, die allen Medienarmen gemeinsam zugeordnet ist, und Kupplungen zur Auswahl des oder der zu schwenkenden Medienarme(s), die geeignet sind, die zu bewegenden Medienarme bzw. den zu bewegenden Medienarm mit der Antriebseinheit derart zu verbinden, daß das Drehmoment der Antriebseinheit auf den jeweiligen Medienarm übertragen wird.

Tritt der Antrieb nun in Aktion, so wird ausschließlich der Medienarm bewegt, der über eine Kupplung mit Antrieb verbunden ist. Dabei können theoretisch auch zwei von z.B. vier Medienarmen gleichzeitig bewegt bzw. geschwenkt werden.

Die Antriebseinheit wird üblicherweise ein Motor sein, d.h. ein Druckmittelmotor (Hydraulikmotor) oder ein Elektromotor (z.B. Schrittmotor) sein. Der Antrieb kann mehr oder weniger direkt oder über ein Getriebe erfolgen. Der Antrieb muß im Stande sein eine Hinund Herbewegung zu bewirken.

Die Schwenkbewegung des Medienarms erfolgt zwischen einer Ruheposition und einer Arbeitsposition, oder er wird im eingeschalteten Zustand (Medium fließt) zwischen zwei Umkehrpositionen hin- und herbewegt. Der Schwenkbereich kann einen Winkel von 10° bis 180° umfassen.

In einer Ausführungsform sind die Medienarme auf Naben montiert, die sich auf derselben Welle befinden. Sie besitzt Kupplungen, die die Welle mit einer oder mehreren Naben zur Übertragung des Drehmomentes von der Welle auf die Nabe verbinden.

Im Ruhezustand der Medienarme sind die Naben auf der Welle frei drehbar und werden so, wenn sich die Welle dreht, nicht mitgedreht. Wird mittels Kupplung eine Nabe mit der Welle verbunden, so dreht sich die Nabe mit und der auf ihr montierte Medienarm wird entsprechend geschwenkt.

Die Kupplungen bestehen bei einer weiteren Ausführungsform aus einer Feder, die auf der Welle montiert ist und mindestens einer Nabennut pro Nabe, in die die Feder eingreifen kann, wobei die Feder durch Verschieben der Welle in achsialer Richtung so verschoben werden kann, daß sie in die Nabennut der Nabe, deren Medienarm bewegt werden soll, eingreifen kann.

In diesem Fall wird, da die Feder jeweils nur in die Nut einer Nabe eingreifen kann, immer nur eine Nabe durch die Welle gedreht und damit nur ein Medienarm angetrieben. Ein Wechsel von einem Medienarm zu einem anderen kann nur in der Ruhestellung erfolgen, da die Feder sonst nicht in die Nabennut eingreifen kann. In der Ruhestellung wird nun durch Heben oder Senken, d.h. Verschieben der Welle entlang ihrer Achse die Feder verschoben, die so in die gewünschte Nabennut eingreift und so die Antriebseinheit über Welle und Nabe mit dem Medienarm kuppelt.

Soll die Antriebseinheit dabei nicht in achsialer Richtung mitbewegt werden, so ist die Welle am drehenden Teil des Antriebes so befestigt, daß beim Verschieben der Welle in achsialer Richtung der Antrieb nicht verschoben wird.

Dies kann z.B. durch eine Welle geschehen, die die Form einer Keilwelle (oder Zahnwelle) hat, die achsial verschiebbar mit einer Keilwellennabe (oder Nabe mit Innenverzahnung) verbunden ist. Wird nun die Keilwellennabe durch die Antriebseinheit getrieben, so überträgt sich das Drehmoment auf die Keilwelle unabhängig davon, welche achsiale Lage die Nabe zur Welle hat.

Eine weitere Ausführungsform ist vorgesehen, bei der die Welle in achsialer Richtung durch eine pneumatische Einrichtung bewegt wird, die eine der Anzahl der Medienarme entsprechende Anzahl von Positionen einnehmen kann.

Im Gegensatz zu der Ausführungsform, bei der eine Welle die Naben, auf denen sich die Medienarme befinden, antreibt, treibt bei einer weiteren Ausführungsform die Antriebseinheit einen Mitnehmer an, und jedem Medienarm ist eine Kupplung zugeordnet, die in den Mitnehmer eingreifen kann.

Die Kupplung kann nun nach Bedarf den Mitnehmer mit dem drehbar gelagerten Medienarm verbinden. Bei dieser Ausführungsform können auch zwei oder mehrere der Medienarme gleichzeitig bewegt werden. Die bewegten Medienarme bleiben bei gleichzeitigem Schwenken zueinander parallel.

In einer Ausführungsform ist der Mitnehmer eine Leiste, die sich parallel und im Abstand zu der Achse befindet, auf der die Medienarme frei drehbar angebracht sind. Die Leiste kann eine Rotationsbewegung um diese Achse durchführen. Die Kupplung kann in diesem Fall ein Zapfen sein, der in ein ihm zugeordnetes Loch in der Leiste eingreift, oder eine Gabel, die die Leiste beidseitig umschließt. Der Antrieb einer solchen Kupplung kann pneumatisch oder über einen Elektromagneten erfolgen.

Ein weiterer Teil der Erfindung ist eine Vorrichtung gemäß einem der Ansprüche 9 bis 12.

Scheibenförmige Gegenstände können beispielsweise Halbleiterscheiben (z.B. aus Silizium) sein. Die zum Behandeln verwendeten Medien können Flüssigkeiten wie z.B. Kunstharzlösungen (z.B. Photoresist), Reinigungsmittel, Ätzmittel oder Lösungsmittel, aber auch Gase wie Luft oder Reinststickstoff sein.

Der Träger kann ein Vakuum-Träger oder auch ein Träger nach dem Bemoulli-Prinzip sein.

Bei einer Ausführungsform der Vorrichtung sind die Austrittsöffnungen der Mediendüsen im wesentlichen senkrecht auf die ebene Fläche des Trägers, die dem scheibenförmigen Gegenstand zugekehrt ist, gerichtet. "Im wesentlichen senkrecht" soll hier auch einen Bereich von +/- 45° mit einschließen. Diese Ausrichtung ist insbesondere dann wichtig, wenn eine Flüssigkeit im laminaren Strom unter wenig Druck aus der Mediendüse austritt.

Eine weitere Ausführungsform sieht vor, daß die Vorrichtung Mittel enthält, um den Träger (und mit ihm den darauf befindlichen scheibenförmigen Gegenstand) in Rotation zu versetzen. Wird Flüssigkeit auf die Oberfläche des Gegenstandes aufgebracht, so wird diese von seinem Rand abgeschleudert.

In einer Ausführungsform ist die Rotationsachse des Trägers im wesentlichen parallel zur Schwenkachse des Trägers.

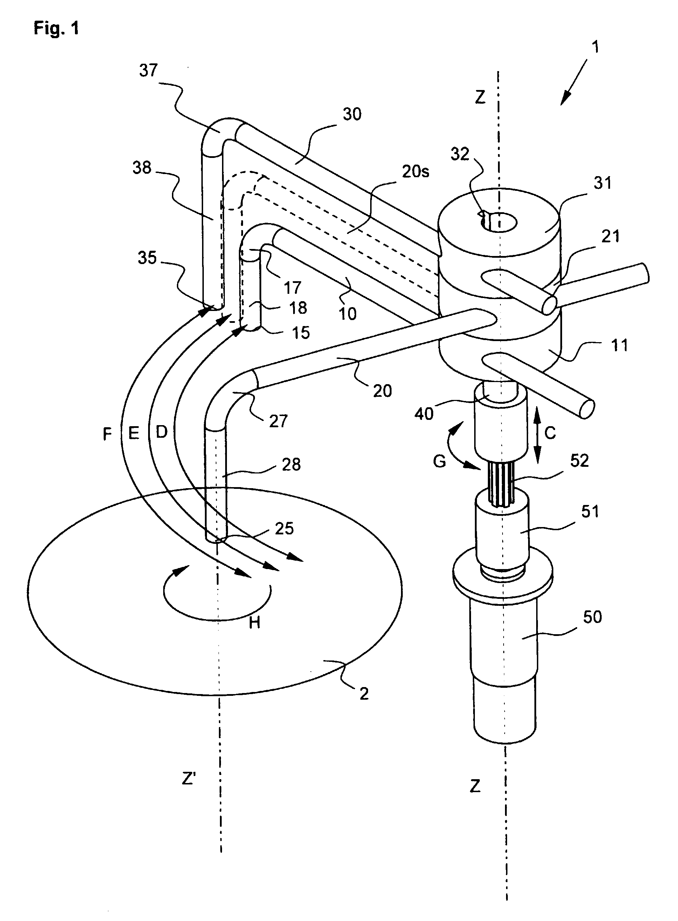

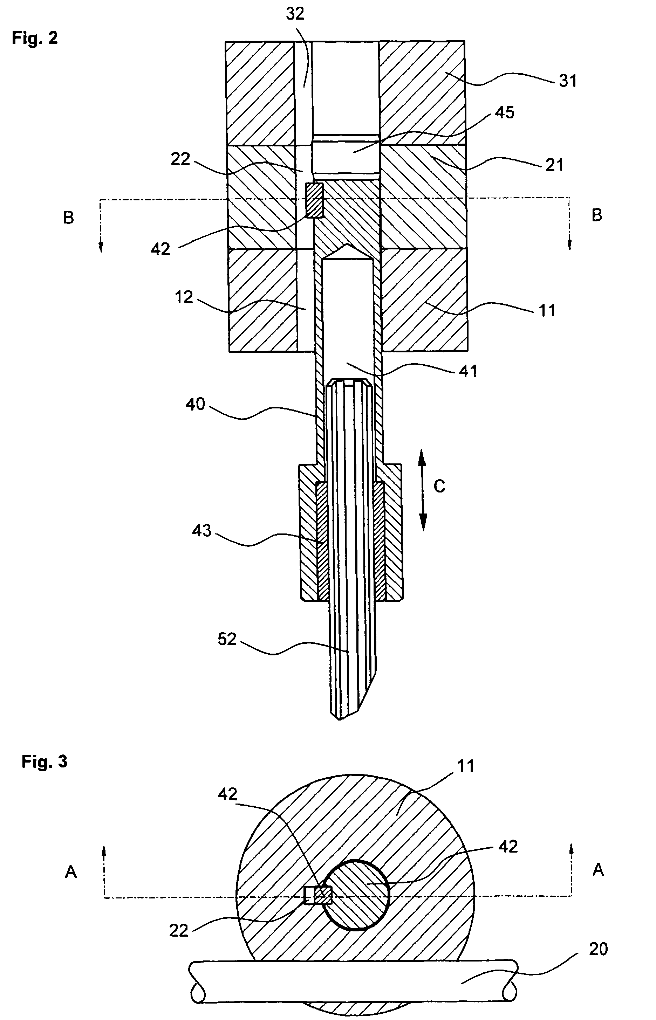

Weitere Einzelheiten, Merkmale und Vorteile der Erfindung ergeben sich aus der nachstehenden Beschreibung des in den Zeichnungen gezeigten Ausführungsbeispiels der Erfindung. Es zeigt Fig. 1 einen schematischen Schrägriß einer erfindungsgemäßen Ausführungsform 1 mit drei Medienarmen 10, 20 und 30. Die Fig. 2 zeigt einen Längsschnitt (A-A in Fig. 3) und Fig. 3 einen Querschnitt (B-B in Fig. 2) eines Teils der Mechanik dieser Ausführungsform.

Mit 2 ist der scheibenförmige Gegenstand (Wafer) bezeichnet, auf den die Medien, die durch die Düsen der Medienarme ausgetragen werden sollen, aufgebracht werden. Der Pfeil H stellt die Rotationsbewegung des Wafers um seine Achse Z' während der Behandlung dar. Die Rotationsachse Z' ist parallel zur Schwenkachse Z, um die die Medienarme geschwenkt werden.

Die Medienarme 10, 20 und 30 sind im wesentlichen senkrecht zur, jedoch im Abstand von der senkrechten Achse Z, um die sie geschwenkt werden können, auf den Naben 11, 21 und 31 montiert. Mit anderen Worten die Medienarme sind waagrecht gelagert. Die Medienarme 10 und 30 befinden sich in Fig. 1 in Ruhestellung (Stand-By-Position). Strichliert dargestellt ist die Ruhestellung 20s des mittleren Medienarm 20. In Ruheposition liegen die drei Medienarme parallel übereinander.

Jeder der drei Medienarme 10, 20 und 30 ist als Rohr ausgeführt. Das zu fördernde Medium kann entweder direkt in diesem Rohr geführt werden oder in einer Leitung, die in das Rohr eingeführt worden ist. Die Medienarme sind an ihren Austragsseiten mit Knien (17, 27, 37) um 90° nach unten gebogen. Dadurch weisen die Düsen (15, 25, 35) senkrecht nach unten. Das aus den Düsen austretende Medium trifft so senkrecht auf die Oberfläche der zu behandelnde Scheibe 2 auf.

Um für alle drei Medienarme gewährleisten zu können, daß der Abstand der Düsen (15, 25, 35) zur Scheibe 2 gleich ist, müssen die Endstücke 18, 28 bzw. 38 jedes Medienarms - der senkrechte Teil zwischen Knie und Düse - verschieden lang sein. Dementsprechend ist das Endstück 18 des unteren Medienarm 10 kürzer als das Endstück 28 des mittleren und dieses wiederum kürzer als das Endstück 38 des oberen.

Damit die Medienarme einander bei ihren Schwenkbewegungen nicht behindern, befinden sich die Knie im entsprechenden Abstand zur Schwenkachse Z, d.h. das Knie 17 des unteren Medienarms ist näher der Achse Z und das Knie 37 des oberen Medienarms ist weiter weg von der Achse als das Knie 25 des mittleren Medienarms.

Da sich die Düsen nun in der selben Ebene senkrecht zur Schwenkachse Z und im unterschiedlichen Abstand zu dieser Achse Z befinden, werden sie beim Schwenken der Medienarme entlang von Bögen konzentrischer Kreise geführt, dargestellt durch die Pfeile D, E und F.

Wenn es erforderlich ist, daß die Medien auf der selben Stelle (z.B. Waferzentrum) auf dem Wafer auftreffen, so müssen die Düsen entsprechend ausgerichtet werden. Dies kann dadurch geschehen, daß das Knie 17 des unteren Medienarms weniger als 90° (z.B. 80°) und das Knie 37 des oberen Medienarms mehr als 90° (z.B. 100°) gekrümmt werden (nicht dargestellt).

Die Naben 11, 21 und 31, auf denen die Medienarme montiert sind, befinden sich übereinander und haben die selbe Achse Z. In den Naben befindet sich die Welle 40, die achsial verschiebbar ist. Die Verschiebebewegung ist durch den Pfeil C dargestellt.

Die Naben sind über außenseitig angebrachte Lager (nicht dargestellt) in einem gemeinsamen Gehäuse (nicht dargestellt) gehalten. Das Gehäuse besitzt entsprechende Öffnungen um die Medienarme nicht in ihrer Bewegung zu behindern.

Jede Nabe 11, 21 bzw. 31 besitzt innenseitig eine Nabennut 12, 22 bzw. 32. Befinden sich die Medienarme in Ruheposition, so fluchten die Nabennuten.

Auf der Welle 40 ist eine Feder 42 montiert, d.h. die Feder ist in einer Wellennut eingepreßt. Die Feder 42 kann in jede der Nabennuten 12, 22 und 32 eingreifen; sie dient der Drehmomentübertragung von der Welle auf die gewünschte Nabe. Die Verschiebung der Feder 42 erfolgt durch achsiale Verschiebung C der Welle 40. Dies kann durch einen Pneumatikzylinder mit drei Positionen geschehen (nicht dargestellt). Um die Welle 40 beim Verschieben in Richtung C nicht mit der Innenseite der Nabe in Berührung zu bringen, ist an ihrem oberen Ende ein Führungselement 45 (in Fig. 2 nicht geschnitten) angebracht.

Da die Nabennuten 12, 22 und 32 nur in der Ruheposition aller Medienarme fluchten, ist auch nur in dieser Position ein Verschieben der Welle 40 (und mit ihr der Feder 42) möglich.

In Fig. 2 und Fig. 3 greift die Feder 42 in die Nabennut 22 der mittleren Nabe 21 ein (dargestellt ist hier die Ruheposition). Wird nun die Welle 40 um einen Winkel gedreht (Pfeil G in Fig. 1), so wird der mittlere Medienarm 20 um den selben Winkel geschwenkt (Pfeil E), wie in Fig. 1 dargestellt. Die Arbeitsposition kann starr sein, oder der Medienarm wird, während Medium ausgetragen wird, zwischen zwei Umkehrpunkten hin- und herbewegt.

Die Welle 40 wird über eine in ihr eingepreßte Keilwellennabe 43 durch eine Keilwelle 52 angetrieben. Die Keilwelle 52 ist über ein Verbindungsstück 51 mit dem Motor 50 verbunden. Die Welle 40 ist im Bereich 41 hohl, um, wenn sie verschoben wird, in ihr der Keilwelle 52 Platz zu geben. Beim achsialen Verschieben der Welle 40 wird die Relativlage von Keilwelle 52 zu den Naben 11, 21 und 31 nicht verändert. Dadurch ist es möglich das Gehäuse (nicht dargestellt), in dem die Naben gelagert sind, und den Motor 50 auf starr miteinander verbundenen Elementen (z.B. einer gemeinsamen Trägerplatten) zu montieren.

## Patentansprüche

1. Einrichtung (1) zum Austrag von zwei oder mehreren Medien aus Mediendüsen (15, 25, 35), bei der jede Mediendüse sich auf je einem Medienarm (10, 20, 30) befindet, mit je einer Aufhängung (11, 21, 31) für einen Medienarm, sodaß die Medienarme getrennt von einander Schwenkbewegungen (D, E, F) um die selbe Achse (Z) durchführen können dadurch gekennzeichnet, daß die Medienarme zur Durchführung der Schwenkbewegung frei drehbar auf einer gemeinsamen Achse (Z) so angebracht sind, daß sie einander bei Durchführung der Schwenkbewegung nicht behindern.

2. Einrichtung nach Anspruch 1 mit einer Antriebseinheit (50), die allen Medienarmen (10,20,30) gemeinsam zugeordnet ist, zur Durchführung der Schwenkbewegungen, und Kupplungen, zur Auswahl des oder der zu schwenkenden Medienarme, die geeignet sind, die zu bewegenden Medienarme bzw. den zu bewegenden Medienarm mit der Antriebseinheit derart zu verbinden, daß das Drehmoment der Antriebseinheit auf den Medienarm übertragen wird.

3. Einrichtung nach Anspruch 2, bei der die Medienarme auf Naben (11, 21, 31) montiert sind, die sich auf derselben Welle (40) befinden und Kupplungen, die die Welle mit einer oder mehreren Naben zur Übertragung des Drehmomentes von der Welle auf die Nabe verbinden.

4. Einrichtung nach Anspruch 3, bei der die Kupplungen aus einer Feder (42), die auf der Welle montiert ist und mindestens eine Nabennut (12, 22, 32) pro Nabe besteht, in die die Feder eingreifen kann, wobei die Feder durch Verschieben der Welle in achsialer Richtung (C) so verschoben werden kann, daß sie in die Nabennut der Nabe, deren Medienarm bewegt werden soll, eingreifen kann.

5. Einrichtung nach Anspruch 4, bei der die Welle am drehenden Teil des Antriebes (52) so befestigt ist, daß beim Verschieben der Welle in achsialer Richtung der Antrieb nicht verschoben wird.

6. Einrichtung nach Anspruch 5, bei dem die Welle in achsialer Richtung durch eine pneumatische Einrichtung bewegt wird, die eine der Anzahl der Medienarme entsprechende Anzahl von Positionen einnehmen kann.

7. Einrichtung nach Anspruch 2, bei der die Antriebseinheit einen Mitnehmer antreibt und jedem Medienarm eine Kupplung zugeordnet ist, die in den Mitnehmer eingreifen kann.

8. Einrichtung nach Anspruch 7, bei der der Mitnehmer eine Leiste ist, die sich parallel und im Abstand zu der Achse befindet, auf der die Medienarme frei drehbar angebracht sind, und diese Leiste eine Rotationsbewegung um diese Achse durchführen kann.

9. Vorrichtung mit mindestens einer der Einrichtungen gemäß einem der vorgehenden Ansprüche zum Behandeln von jeweils einem scheibenförmigen Gegenstand (2) mit einem Medium mit einem Träger zum Halten des scheibenförmigen Gegenstand.

10. Vorrichtung nach Anspruch 9, wobei die Austrittsöffnungen der Mediendüsen (15, 25, 35) im wesentlichen senkrecht auf die ebene Fläche des Trägers, die dem scheibenförmigen Gegenstand zugekehrt ist, gerichtet ist.

11. Vorrichtung nach Anspruch 10 mit Mitteln, um den Träger in Rotation zu versetzten.

12. Vorrichtung nach Anspruch 11, bei der die Rotationsachse des Trägers (Z') im wesentlichen parallel zur Schwenkachse (Z) der Medienarme ist.

## Claims

1. Device (1) for discharging two or more media from media nozzles (15, 25, 35) in which each media nozzle is located on one media arm (10, 20, 30), each with a suspension device (11, 21, 31) for each media arm, so that the media arms can perform swivel movements (D, E, F) about the same axis (Z) separately from each other, characterised in that the media arms are mounted so as to be freely rotatable on a common axis (Z) in order to perform the swivel movement such that they do not impede each other when performing the swivel movement.

2. Device according to claim 1 with a drive unit (50) which is associated with all of the media arms (10, 20, 30) in common in order to perform the swivel movements, and with couplings for selecting the media arm or arms to be swivelled and suitable for connecting the media arms to be moved or arm to be moved to the drive unit in such a manner that the torque of the drive unit is transmitted to the media arm.

3. Device according to claim 2, in which the media arms are mounted on hubs (11, 21, 31), which are located on the same shaft (40), and in which couplings connect the shaft to one or more hubs in order to transmit the torque from the shaft to the hub.

4. Device according to claim 3, in which the couplings comprise a key (42), which is mounted on the shaft, and at least one keyway (12, 22, 32) per hub, in which the key can engage, the key being able to be displaced by displacement of the shaft in an axial direction (C) such that said key can engage in the keyway of the hub, the media arm of which is to be moved.

5. Device according to claim 4, in which the shaft is mounted on the rotating part of the drive (52) such that, when the shaft is displaced in an axial direction, the drive is not displaced.

6. Device according to claim 5, in which the shaft is moved in an axial direction by a pneumatic device which can adopt a number of positions corresponding to the number of media arms.

7. Device according to claim 2, in which the drive unit actuates a driver and a coupling is associated with each media arm and can engage in the driver.

8. Device according to claim 7, in which the driver is a strip which is situated parallel to, and at a spacing to, the axis on which the media arms are mounted to rotate freely, and this strip can perform a rotational movement about this axis.

9. Device with at least one of the devices according to the preceding claims for treating respectively one disc-shaped object (2) with a medium, with a a carrier for holding the disc-shaped object.

10. Device according to claim 9, the outlet openings of the media nozzles (15, 25, 35) being orientated substantially parallel to the flat surface of the carrier which faces the disc-shaped object.

11. Device according to claim 10, with means for making the carrier rotate.

12. Device according to claim 11, in which the axis of rotation of the carrier (Z') is substantially parallel to the swivel axis (Z) of the media arms.

## Revendications

1. Dispositif (1) pour appliquer deux ou plusieurs substances à l'aide de buses d'application de substance (12, 25, 35), dans lequel chaque buse d'application de substance est disposée sur un bras d'application de substance (10, 20, 30), avec un support (11, 21, 31) associé à chaque bras d'application de substance, de telle sorte que les bras d'application de substance puissent effectuer indépendamment les uns des autres des mouvements de pivotement (D, E, F) autour du même axe (Z), caractérisé par le fait que les bras d'application de substance, pour l'exécution du mouvement de pivotement, sont montés libres en rotation sur un axe (Z) commun de manière telle qu'ils ne se gênent pas dans leur mouvement de pivotement.

2. Dispositif selon la revendication 1, comprenant une unité d'entraînement (50) qui est commune à tous les bras d'application de substance pour exécuter les mouvements de pivotement et des moyen de couplage pour sélectionner le ou les bras d'application de substance à faire pivoter, qui sont adaptés pour coupler à l'unité d'entraînement les ou le bras d'application de substance à faire pivoter, de telle sorte que le couple de l'unité d'entraînement soit transmis au bras d'application de substance.

3. Dispositif selon la revendication 2, dans laquelle les bras d'application de substance sont montés sur des moyeux (11, 21, 31) qui se trouvent sur le même arbre (40) et les moyens de couplage relient l'arbre à un ou à plusieurs moyeux aux fins de transmettre le couple de l'arbre au moyeu.

4. Dispositif selon la revendication 3, dans lequel les moyens de couplage sont formés d'une clavette (42) montée sur l'arbre et d'au moins une rainure (12, 22, 32) dans chaque moyeu, dans laquelle la clavette peut s'engager, la clavette pouvant être déplacée par déplacement de l'arbre dans la direction axiale (C) de manière à ce qu'elle pénètre dans la rainure du moyeu associé au bras d'application de substance à déplacer.

5. Dispositif selon la revendication 4, dans lequel l'arbre est fixé à la partie tournante de l'entraînement (52) de manière telle que l'entraînement ne soit pas déplacé lorsque l'arbre est déplacé dans la direction axiale.

6. Dispositif selon la revendication 5, dans lequel l'arbre est déplacé dans la direction axiale par un dispositif pneumatique qui peut prendre un nombre de positions qui correspond au nombre de bras d'application de substance.

7. Dispositif selon la revendication 2, dans lequel l'unité d'entraînement agit sur un entraîneur et à chaque bras d'application de substance est associé un moyen de couplage qui peut venir en prise avec l'entraîneur.

8. Dispositif selon la revendication 7, dans lequel l'entraîneur est une tige qui est disposée parallèlement à l'axe, à distance de celui-ci sur laquelle les bras d'application de substance sont montés libres en rotation et ladite tige peut exécuter un mouvement de rotation autour de l'axe.

9. Installation comportant au moins un des dispositifs selon une des revendications précédentes pour traiter chaque fois un objet en forme de disque à l'aide d'une substance, comprenant un support pour tenir l'objet en forme de disque.

10. Installation selon la revendication 9, dans laquelle les orifices de sortie des buses d'application de substance (15, 25, 35) sont dirigées essentiellement perpendiculairement à la surface plane du support, tournée vers l'objet en forme de disque.

11. Installation selon la revendication 10, comprenant des moyens pour mettre le support en rotation.

12. Installation selon la revendication 11, dans laquelle l'axe de rotation du support (Z') est essentiellement parallèle à l'axe de pivotement (Z) des bras d'application de substance.
